# EUROPEAN PATENT APPLICATION

(11) **EP 1 764 651 A2**
(43) Date of publication of application: **21.03.2007**
(21) Application number: 06291430.4
(22) Date of filing: 11.09.2006
(51) Int. Cl.: G03F 7/033

(54) **Water-soluble photopolymer composition for flexographic printing and water-developable photosensitive original printing plate for flexographic printing**

(30) Priority: 16.09.2005 JP 2005270930
(71) Applicant: TOKYO OHKA KOGYO CO., LTD., Kawasaki-shi, Kanagawa 211-0012 (JP)
(72) Inventor: Katayose, Yoshiaki, Tokyo Ohka Kogyo Co. Ltd., Kawasaki-shi, Kanagawa 211-0012 (JP); Hirai, Takaaki, Tokyo Ohka Kogyo Co. Ltd., Kawasaki-shi, Kanagawa 211-0012 (JP)
(74) Representative: Perin, Georges

(57) **Abstract**

A water-soluble photopolymer composition for flexographic printing is provided which can be water developed and can form a photosensitive original printing plate for flexographic printing having a good flexibility and impact resilience as well as an adequate Shore hardness value. The water-soluble photopolymer composition for flexographic printing contains a water-soluble resin component (A), a photopolymerizable monomer (B) and a photopolymerization initiator (C), in which the water-soluble resin component (A) includes a first partially saponified polyvinyl acetate having a saponification degree ranging from 20 to 70 mole% (A1) and a second partially saponified polyvinyl acetate having a saponification degree ranging from 70 to 95 mole% (A2).

## Description

This application is based on and claims the benefit of priority from Japanese Patent Application No. 2005-270930, filed on 16 September 2005, the content of which is incorporated herein by reference.

### BACKGROUND OF THE INVENTION

### Field of the Invention

The present invention relates to a water-soluble photopolymer composition for flexographic printing which enables the formation of stereographic patterns, such as printing patterns, having superior properties in dimensional stability, humidity resistance, flexibility, impact resilience, water resistance and stable preservation, of an original printing plate for flexographic printing which employs a water-insoluble printing ink, and to a water-soluble photosensitive original printing plate for flexographic printing obtained thereby.

### Related Art

Photopolymer compositions used for the fabrication of a printing plate include alcohol-soluble types, organic solvent-soluble types, and water-soluble types. However, water-soluble compositions are mainly used because of safe treatment processing and good health management of workers.

It has been suggested to include polyvinyl acetate, a polymerizable monomer, and a photopolymerization initiator in these water-soluble photopolymer compositions (for example, Patent Documents 1, 2 and 3). The water-soluble photopolymer composition of Patent Document 1 contains a reaction product of a partially saponified polyvinyl acetate (having a saponification degree ranging from 63 to 99 mole%) with monoaldehydes and dialdehydes (A), a photopolymerizable monomer having at least one unsaturated ethylene bond within the molecule (B), a photopolymerization initiator (C), and, if desired, a plasticizer (D). Also, the water-soluble photopolymer composition of Patent Document 2 contains at least a base resin (A), a photopolymerization initiator (B), a photopolymerizable unsaturated compound having an ethylene double bond within the molecule (C) and a UV-absorbing compound (D), in which the base resin (A) includes a partially saponified polyvinyl acetate having a saponification degree ranging from 60 to 99 mole%. Further, the water-soluble photopolymer composition of Patent Document 3 contains a partially saponified polyvinyl acetate having a saponification degree ranging from 60 to 99 mole% (A), a monomer containing a photopolymerizable unsaturated group (B) and a photopolymerization initiator (C).

Japanese Unexamined Patent Application Publication No. 07-319160 (Patent Document 1).

Japanese Unexamined Patent Application Publication No. 2002-023349 (Patent Document 2).

Japanese Unexamined Patent Application Publication No. 2002-182382 (Patent Document 3).

The aforementioned water-soluble photopolymer compositions basically contain a partially saponified polyvinyl acetate with a saponification degree ranging from 60 to 99 mole% or from 63 to 99 mole%, a photopolymerizable monomer and a photopolymerization initiator. These compositions are used to fabricate original printing plates for relief printing. However, these original printing plates for relief printing are fabricated mainly for the specific purpose of letterpress printing which is one type of relief printing. Thus, if these original printing plates for relief printing are used for flexographic printing which is another type of relief printing, the printing layer formed in a pattern has a relatively high hardness, resulting in insufficient ink adhesion to the edge portions of the printing layer. Thus, it is not possible to obtain printed products of high quality due to the generation of abrasion with the printing.

A rubber-based original printing plate is considered to be an original printing plate which can form a flexible printing layer suitable for flexographic printing. A rubber-based original printing plate is obtained via a pattern exposure of a resin layer made of a photopolymer composition containing a thermoplastic elastomer such as styrene/butadiene/styrene or styrene/isoprene/styrene, a photopolymerizable monomer, and a photopolymerization initiator. In this case, an organic solvent must be used for development of the patterned exposure. Thus, the rubber-based original printing plate is not useful from the viewpoint of using a highly safe water-based developer. Moreover, if a rubber-based original printing plate is used, since it has a low chemical resistance to components contained in UV ink and oil ink for flexographic printing, the patterned resin layer tends to expand and the hardness of the plate surface decreases. Further, the increase in plate thickness causes thickening of printing image lines, spreading of dots, appearance of marginal zones, and it is not possible to obtain printed products having high quality.

### SUMMARY OF THE INVENTION

The present invention has been made in view of the problems mentioned above. An object of the present invention is to provide a water-soluble photopolymer composition for flexographic printing which can be water developed and can form a photosensitive original printing plate for flexographic printing having a good flexibility and impact resilience as well as an adequate Shore hardness value, and a water-soluble photosensitive original printing plate for flexographic printing obtained thereby.

As a result of diligent investigation done by the inventors in order to achieve this object, they found that the desired characteristics of the water-soluble photopolymer composition for flexographic printing can be attained by a resin composition containing a water-soluble resin component (A), a photopolymerizable monomer (B) and a photopolymerization initiator (C), in which the water-soluble resin component (A) includes a first partially saponified polyvinyl acetate having a saponification degree ranging from 20 to 70 mole% (A1), and a second partially saponified polyvinyl acetate having a saponification degree ranging from 70 to 95 mole% (A2).

The present invention has been made based on the aforementioned finding. More specifically, in a first aspect of the present invention, a water-soluble photopolymer composition is provided for flexographic printing. The composition contains a water-soluble resin component (A), a photopolymerizable monomer (B), and a photopolymerization initiator (C), in which the water-soluble resin component (A) includes a first partially saponified polyvinyl acetate having a saponification degree ranging from 20 to 70 mole% (A1) and a second partially saponified polyvinyl acetate having a saponification degree ranging from 70 to 95 mole% (A2).

In a second aspect of the present invention, a water-soluble photosensitive original printing plate is provided for flexographic printing. The original printing plate comprises a photosensitive layer formed on a support, made of the water-soluble photopolymer composition in accordance with the first aspect of the present invention.

In the water-soluble photopolymer composition of the present invention, the component (A) is a water-soluble resin component which includes a first partially saponified polyvinyl acetate having a saponification degree ranging from 20 to 70 mole% (A1), and a second partially saponified polyvinyl acetate having a saponification degree ranging from 70 to 95 mole% (A2). By using the component (A), it is possible to obtain a chemical resistance to components contained in UV ink and oil ink for flexographic printing. Particularly, it is possible to obtain a chemical resistance to components contained in UV ink and good printing life. Also, using the components (A1) and (A2) within the aforementioned concentration ranges, it is possible to obtain a good flexibility and impact resilience as well as a chemical resistance to components contained in UV ink and oil ink. An average degree of polymerization of the water-soluble resin component (A) is preferably in the range from 300 to 2,000. The average degree of polymerization within the aforementioned range is preferably used to obtain a composition with superior development characteristics.

In the water-soluble photopolymer composition of the present invention, if the amount of the first partially saponified polyvinyl acetate (A1) is insufficient or if it is absent, the patterned printing layer obtained from the photopolymer composition becomes rigid with a Shore A hardness (JIS K6253) of 65° or more. Thus, the flexibility suitable for flexographic printing is not achieved. The water-soluble photopolymer composition of the present invention can attain a Shore A hardness of the printing plate ranging from 25° to 65° which is suitable for flexographic printing. The Shore A hardness is preferably within a range from 30° to 60°.

In the aforementioned configuration, it is desirable to blend 10 to 80 weight% of the first partially saponified polyvinyl acetate (A1), and 20 to 90 weight% of the second partially saponified polyvinyl acetate (A2) for 100 weight% of the water-soluble resin component (A). This blending quantity enables a good flexibility and impact resilience.

Also, it is desirable for the water-soluble resin component (A) to contain a partially saponified polyvinyl acetate obtained from a reaction with an acrylic compound having an N-methyl group. When the component (A) contains a partially saponified polyvinyl acetate obtained from a reaction with an acrylic compound having an N-methyl group, the strength of the composition increases, resulting in an improved printing resistance (printing life). The acrylic compound having an N-methyl group may be blended preferably in 2 to 40 weight%, more preferably 5 to 30 weight%, for 100 weight% of the component (A). A blending quantity within the aforementioned range results in an improved printing resistance (printing life).

Acrylic compounds having an N-methylol group may include, for example, N-methylol acrylamide, N-methylol methacrylamide, N-methyl-N-methylol acrylamide, N-methyl-N- methylol methacrylamide, N-ethyl-N-methylol acrylamide, N-ethyl-N-methylol methacrylamide. However, N-methylol acrylamide and N-methylol methacrylamide are particularly preferable. These compounds may be used either singularly or in combinations of two or more.

In the composition of the present invention, a photopolymerization monomer is used as the component (B). The photopolymerization monomer includes, for example, unsaturated carboxylic acids such as acrylic acid and methacrylic acid; unsaturated carboxylic esters such as methyl acrylate, ethyl acrylate, isopropyl acrylate, n-propyl acrylate, isobutyl acrylate, n-butyl acrylate, 2-ethyl hexyl acrylate, lauryl acrylate, stearyl acrylate, ethylene glycol monoacrylate, diethylene glycol monoacrylate, propylene glycol monoacrylate, and, polyethylene glycol monoacrylate, polyethylene glycol monomethoxy monoacrylate and polyethylene glycol diacrylate having a molecular weight ranging from 200 to 1000, cyclohexyl acrylate, N,N'-dimethyl aminoethyl acrylate, hydroxypropyl acrylate, hydroxyethyl acrylate, tetraethylene glycol diacrylate, trimethylpropane triacrylate, pentaerythritol acrylate and methacrylates corresponding thereto; unsaturated carboxylic amides such as acrylamide, N-methylol acrylamide, N-ethylol acrylamide, N-propylol acrylamide, diacetone acrylamide, diacrylamide dimethylene ether, methylene bisacrylamide and methacrylamides corresponding thereto; unsaturated nitriles such as acrylonitrile and methacrylonitrile, and unsaturated sulfonic acids such as sodium allylsulfonate, sodium methacryl sulfonate, trimethylol propane triallyl sulfone acrylate and derivatives thereof.

These photopolymerization monomers may be used either singularly or in combinations of two or more. The photopolymerization monomer may be blended preferably in 10 to 120 weight%, more preferably in 30 to 110 weight%, for 100 weight% of the component (A). If the amount is 10 weight% or more, a good image forming capacity is obtained. If the amount is 120 weight% or less, it is possible to prevent effusion from the photopolymer plate.

In the composition of the present invention, a photopolymerization initiator is used as the component (C). The photopolymerization initiator to be used in the present invention is not particularly limited and existing photopolymerization initiators may be used to attain the object of the invention. For example, benzophenone derivatives such as benzophenone, 2,4-dihydroxy benzophenone and 2-hydroxy-4-alcoxy benzophenone, benzoin derivatives such as benzoin, benzoin isopropyl ether, benzoin methyl ether, benzoin ethyl ether and benzoin isobutyl ether, and benzyl dimethyl ketal may be used.

These photopolymerization initiators may be used either singularly or in combinations of two or more. The photopolymerization initiator may be blended preferably in 0.5 to 5.0 weight%, more preferably in 1.0 to 3.0 weight%, for 100 weight% of the component (A). If the blending amount is 0.5 weight% or more, photo-hardening is more effectively obtained by the use of the composition. If the blending amount is 5.0 weight% or less, the photopolymerization initiator is effectively used.

The composition of the present invention may contain a plasticizer, a thermal polymerization initiator, a stabilizer, and a dye, if desired, as the component (D) together with the components (A), (B) and (C). Also, a publicly known resin may be added within an amount range which does not destroy the characteristic features of the composition. The plasticizer enables the formation of a printing image having a suitable rubber elasticity, widening the applicability of printing. The plasticizer is not particularly limited and is suitably selected from compounds that provide a desirable rubber elasticity. In particular, however, compounds having a hydroxyl group such as trimethylol propane, glycerin, polyglycerin, ethylene glycol, diethylene glycol, triethylene glycol, tetraethylene glycol, polyethylene glycol, and propylene glycol are suitable.

These plasticizers may be used either singularly or in combinations of two or more. The plasticizer may be blended typically in 80 weight% or less, preferably in 10 to 60 weight%, for 100 weight% of the component (A). If the blending amount is 80 weight% or less, a preferable rubber elasticity is obtained, and the patterned dimensions of the relief part after plate making is largely unaffected by humidity changes.

Also, a thermal polymerization inhibitor may be added, if necessary, to the composition of the present invention. The thermal polymerization inhibitor to be used in the present invention is not particularly limited and existing thermal polymerization inhibitors may be used to attain the object of the invention. For example, quinone derivatives such as hydroquinone, methyl hydroquinone and p-benzoquinone, phenol derivatives such as 2,6-di-tertiary butyl-p-cresol, and nitrobenzene and its derivatives may be used.

These thermal polymerization inhibitors may be used either singularly or in combinations of two or more. The thermal polymerization inhibitors may be blended typically in 2 weight% or less for 100 weight% of the component (A).

To fabricate a printing plate for relief printing using the composition of the present invention, an aqueous liquid containing the components (A), (B), (C) and, if necessary, a plasticizer and a thermal polymerization inhibitor (D) is coated on a suitable support using a conventionally used coating process, then dried to form a photopolymer layer to obtain an original printing plate. The photosensitive layer is preferably formed with a typical thickness ranging from 0.01 to 10 mm. Then, the water-soluble photopolymer layer of the obtained original printing plate is subjected to an exposure for image formation. Upon the exposure, a water development process is conducted to obtain a printing plate for relief printing. The obtained printing plate is used as a flexographic printing plate. Here, wavelengths shorter than 450 nm, particularly wavelengths ranging from 300 to 400 nm are effectively used as an optical source in the exposure. For example, a low-pressure mercury lamp, high-pressure mercury lamp, carbon arc lamp, ultraviolet lamp, chemical lamp or xenon lamp may be used. Particularly, the composition and original printing plate of the present invention have a high chemical resistance to components contained in UV ink, UV varnish and oil ink, and are thus suitable for the use of UV ink, UV varnish and oil ink. Particularly, the composition and original printing plate of the present invention have a superior resistance to monomers contained in UV ink and UV varnish.

The water-soluble photopolymer composition for flexographic printing according to the present invention contains a water-soluble resin component (A), a photopolymerizable monomer (B), and a photopolymerization initiator (C), in which the water-soluble resin component (A) includes a first partially saponified polyvinyl acetate having a saponification degree ranging from 20 to 70 mole% (A1), and a second partially saponified polyvinyl acetate having a saponification degree ranging from 70 to 95 mole% (A2). Due to such a configuration of the water-soluble photopolymer composition for flexographic printing of the present invention, it is possible to obtain an original printing plate suitable for flexographic printing which employs non-aqueous liquids. More specifically, the configuration makes it possible to obtain a water-soluble photosensitive original printing plate having a superior resistance to non-aqueous ink and a suitable flexibility with a Shore A hardness of 65° or less. According to such a water-soluble photosensitive original printing plate, a printing plate with a good ink adhesion can be fabricated which can produce printed products having high quality without generating abrasion, thickening of printed image lines, spreading of dots, or the appearance of marginal zones.

### DETAILED DESCRIPTION OF THE INVENTION

Hereinafter, embodiments of the invention will be described with reference to the examples. However, the invention is not limited by these examples.

In the examples hereinafter, the hardness of the obtained photopolymer layer and the printing suitability of the finally fabricated printing plate were evaluated. The hardness of the photopolymer layer was measured based on Shore A hardness according to the JIS K6253 regulation. The printing suitability was evaluated by visually confirming printed products.

### (Examples 1 to 3)

Three kinds of water-soluble resin components (A) were prepared by mixing a partially saponified polyvinyl acetate having a saponification degree of 33 mole% (A1) (Japan Synthetic Chemical Co., Product Name: L-7514) and a partially saponified polyvinyl acetate having a saponification degree of 73 mole% (A2) (Japan Synthetic Chemical Co., Product Name: NK-04) in a blending ratio in weight% of 10 : 90 (Example 1), 50 : 50 (Example 2) and 80 : 20 (Example 3).

Forty weight% of each water-soluble resin component (A), 7.5 weight% of polyethylene glycol diacrylate (Shin Nakamura Kagaku Co., Product Name: A-400) which was used as the photopolymerizable monomer (B), 1 weight% of benzyl dimethyl ketal which was used as the photopolymerization initiator (C), and 2 weight% of polyglycerin (D) (Sakamoto Pharmaceutical Industry Co., Product Name: polyglycerin #310) were dissolved in a water/methanol (4/1) solution so that the solid concentration reached to 50% in order to prepare a water-soluble photopolymer composition for flexographic printing. Each of the water-soluble photopolymer compositions for flexographic printing was laminated on a polyester sheet (cover film) where a polyvinyl alcohol layer was provided using a T-die. From the three kinds of water-soluble photopolymer compositions, three kinds of sheets having a thickness of 3.4 mm under wet condition were fabricated. These sheets were dried at 60°C for 4 hours. On each dried sheet having a thickness of 1.7 mm (water-soluble photopolymer layer), a polyester sheet with a thickness of 188 µm having an adhesion layer at one side (base film) was layered. Thus, three kinds of water-soluble photosensitive original printing plate for flexographic printing were obtained.

Flexographic printing plates were fabricated by applying a conventional optical formation method, in which back exposure, pattern exposure (main exposure), development, drying, and post exposure were subsequently applied to the aforementioned three kinds of water-soluble photopolymer original printing plate for flexographic printing.

The Shore A hardness was measured for the plate surface (printing layer) of the three kinds of flexographic printing plate. Further, printed products were obtained by conducting flexographic printing using UV ink. There were no problems with the printing plates even though 1,000,000 prints were produced. Each of the obtained printed products was visually evaluated for its printing suitability. Printed products were marked "not good" if there were abrasions, thickening of printed image lines, spreading of dots, or appearance of marginal zones. Otherwise, printed products were marked "good". The results are shown in Table 1.

**(Table 1)**

| | Blending ratio of water-soluble resin component (A) | | Plate hardness Shore A | Printing suitability |
|---|---|---|---|---|
| | L-7514 (weight%) | NK-05 (weight%) | | |
| Example 1 | 10 | 90 | 65° | Good |
| Example 2 | 50 | 50 | 55° | Good |
| Example 3 | 80 | 20 | 40° | Good |

### (Examples 4 to 6)

Water-soluble photopolymer compositions for flexographic printing were prepared similarly to those in Examples 1 to 3, except that the water-soluble photopolymer component (A) was replaced with a water-soluble photopolymer component containing a partially saponified polyvinyl acetate obtained from a reaction with an acrylic compound having an N-methylol group (A), which was prepared by agitating 100 weight% of the water-soluble resin component (A) of Examples 1 to 3 and 15 weight% of N-methylol acrylamide in the presence of an acidic catalyst for 2 hours at 100°C. Further, water-soluble photosensitive original printing plates for flexographic printing were obtained similarly to those in Examples 1 to 3, and afterward flexographic printing plates were produced. Then, the flexographic printing plates were evaluated similarly to those in Examples 1 to 3. The evaluation results were similar to the corresponding results in Examples 1 to 3. There were no problems with the printing plates even though 1,500,000 prints were produced. There was a 50% increase in printing life compared to those in Examples 1 to 3.

### (Comparative Examples 1 and 2)

A water-soluble resin component (A) of Comparative Example 1 was prepared from a partially saponified polyvinyl acetate having a saponification degree of 73 mole% (A2) (Japan Synthetic Chemical Co., Trade Name: NK-04). A water-soluble resin component (A) of Comparative Example 2 was prepared from a partially saponified polyvinyl acetate having a saponification degree of 33 mole% (A1) (Japan Synthetic Chemical Co., Trade Name: L-7514).

Water-soluble photopolymer compositions for flexographic printing were prepared similarly to the composition in Example 1, except that the aforementioned water-soluble resin component (A) was used. Further, water-soluble photosensitive original printing plates for flexographic printing and flexographic printing plates were obtained similarly to those in Example 1.

The Shore A hardness was measured for the plate surface (printing layer) of the two kinds of flexographic printing plate. Further, printed products were obtained by conducting flexographic printing using UV ink. Each of the obtained printed products was visually evaluated for its printing suitability. Printed products were marked "not good" if there were abrasions, thickening of printing image lines, spreading of dots, or appearance of marginal zones. Otherwise, printed products were marked "good". The results are shown in Table 2.

**(Table 2)**

| | Blending ratio of water-soluble resin component (A) | | Plate hardness Shore A | Printing suitability |
|---|---|---|---|---|
| | L-7514 (weight%) | NK-05 (weight%) | | |
| Comparative Example 1 | 0 | 100 | 75° | Not good: ink abrasion |
| Comparative Example 2 | 100 | 0 | 25° | Not good: marginal zones |

As apparent from Tables 1 and 2, flexographic printing plates obtained using the water-soluble photopolymer composition for flexographic printing, in which a water-soluble resin component having a low saponification degree and a water-soluble resin component having a high saponification degree are suitably blended, provides a suitable plate hardness, thereby clear prints can be produced.

As described above, according to the water-soluble photopolymer composition for flexographic printing and the water-soluble photosensitive original printing plate for flexographic printing of the present invention, a printing plate with a good ink adhesion can be fabricated which can produce printed products having a high quality without generating frictions, thickening of printing image lines, spreading of dots, or appearance of marginal zones.

While preferred embodiments of the present invention have been described and illustrated above, it is to be understood that they are exemplary of the invention and are not to be considered to be limiting. Additions, omissions, substitutions, and other modifications can be made thereto without departing from the spirit or scope of the present invention. Accordingly, the invention is not to be considered to be limited by the foregoing description and is only limited by the scope of the appended claims.

## Claims

1. A water-soluble photopolymer composition for flexographic printing comprising a water-soluble resin component (A), a photopolymerizable monomer (B) and a photopolymerization initiator (C),
wherein the water-soluble resin component (A) includes a first partially saponified polyvinyl acetate having a saponification degree ranging from 20 to 70 mole% (A1) and a second partially saponified polyvinyl acetate having a saponification degree ranging from 70 to 95 mole% (A2).

2. The water-soluble photopolymer composition for flexographic printing according to Claim 1, wherein the first partially saponified polyvinyl acetate (A1) is blended at 10 to 80 weight% and the second partially saponified polyvinyl acetate (A2) is blended at 20 to 90 weight% for 100 weight% of the water-soluble resin component (A).

3. The water-soluble photopolymer composition for flexographic printing according to Claim 1 or 2, wherein the water-soluble resin component (A) contains a partially saponified polyvinyl acetate obtained from a reaction with an acrylic compound having an N-methyl group.

4. A water-soluble photosensitive original printing plate for flexographic printing comprising a photosensitive layer formed on a support, made of the water-soluble photopolymer composition for flexographic printing according to Claim 1.

5. The water-soluble photosensitive original printing plate for flexographic printing according to Claim 4, which is used for relief printing employing one type of non-aqueous ink selected from UV ink, UV varnish, and oil ink.
